# DEMANDE DE BREVET EUROPEEN

(11) **EP 2 367 406 A1**
(43) Date de publication de la demande: **21.09.2011**
(21) Numéro de dépôt: 11157223.6
(22) Date de dépôt: 07.03.2011
(51) Int. Cl.: H05K 3/34, H01L 23/498

(54) **Composant électronique à montage en surface**

(30) Priorité: 16.03.2010 FR 1051849
(71) Demandeur: STMicroelectronics (Grenoble 2) SAS, 38000 Grenoble (FR)
(72) Inventeur: Coffy, Romain, 38950 Saint Martin le Vinoux (FR)
(74) Mandataire: de Beaumont, Michel

(57) **Abrégé**

L'invention concerne un composant électronique (51) à montage en surface comprenant des billes (29) fixées à sa face avant et, sur la face avant, une couche de résine de protection (43) d'épaisseur inférieure à la hauteur des billes, dans lequel des rainures (53) s'étendent dans la couche de résine (43) entre des billes de la puce.

## Description

### Domaine de l'invention

La présente invention concerne les composants électroniques à montage en surface, c'est-à-dire des composants dont les plots de contact portent des protubérances conductrices destinées à être fixées directement à des plages de contact d'un support tel qu'une carte de circuit imprimé. La présente invention concerne plus particulièrement des composants à montage en surface susceptibles de résister à des chocs et/ou à des variations de température.

### Exposé de l'art antérieur

Dans les montages en surface, pour minimiser l'encombrement, on utilise souvent des puces nues (dépourvues de boîtier), dont les faces sont seulement recouvertes d'une mince couche isolante, par exemple en oxyde de silicium.

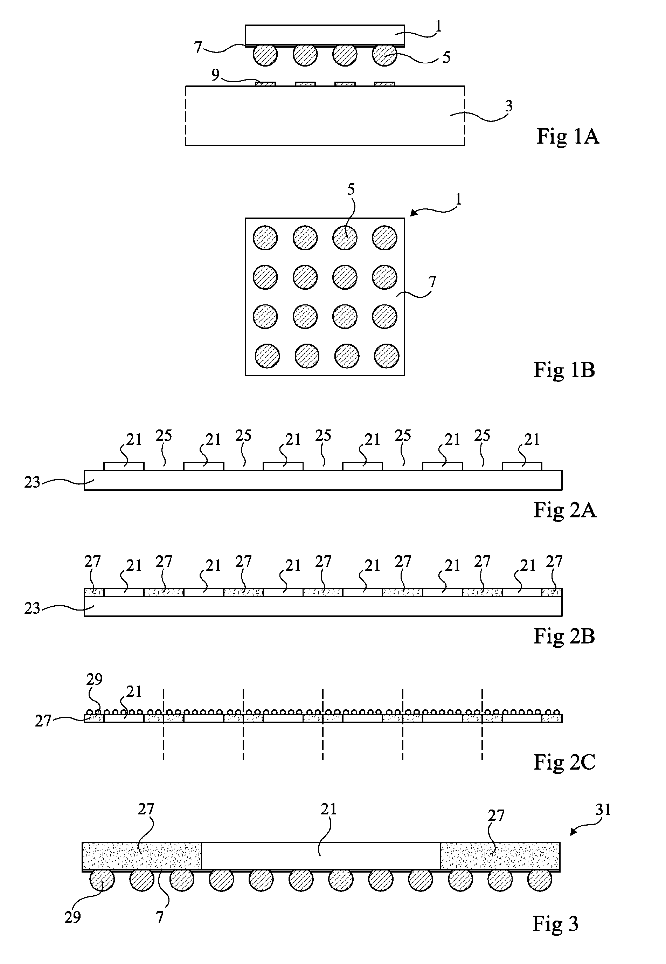

La figure 1A est une vue en coupe représentant de façon schématique une puce à montage en surface 1 adaptée à être montée sur un circuit imprimé 3. La puce 1 comprend, du côté de sa face avant, des billes métalliques 5 fixées à des plots de contact (non visibles sur la figure) de la puce. La puce 1 est une puce nue revêtue seulement d'un empilement d'une mince couche isolante 7 du côté de sa face avant (la face avant peut aussi être recouverte d'un empilement de plusieurs couches isolantes et conductrices dans le cas ou les billes sont reliées à la puce par l'intermédiaire de pistes conductrices). Du côté de sa face avant, le circuit imprimé 3 comprend des plages de contact 9. Lors du montage, les billes 5 de la puce viennent s'appuyer contre les plages de contact 9 du circuit imprimé. Les billes 5 sont alors fixées aux plages 9, par exemple par soudure.

La figure 1B est une vue de la face avant de la puce 1 dans un exemple dans lequel la puce comprend seize billes de contact uniformément réparties en matrice carrée sur toute la surface de la puce.

Dans les montages en surface, la taille des billes limite le nombre des connexions électriques qui peut être réalisé entre la puce et le circuit imprimé. A titre d'exemple, sur une puce carrée de 4 mm de côté, on prévoit généralement, au plus, une matrice de 8 x 8 billes de 0,25 à 0,35 mm de diamètre, avec un pas de 0,4 à 0,5 mm (centre à centre) entre deux billes voisines.

Pour augmenter le nombre de connexions possibles, on a proposé de former, autour de la puce semiconductrice, une extension périphérique en résine, sensiblement de même épaisseur que la puce, cette extension étant adaptée à supporter des billes de contact supplémentaires. L'extension en résine comporte à sa surface des plots de contact et des pistes conductrices pour relier les billes supplémentaires à des zones de la puce à contacter.

Les figures 2A à 2C sont des vues en coupe représentant très schématiquement des étapes de réalisation de puces semiconductrices munies d'extensions périphériques en résine.

La figure 2A illustre une étape au cours de laquelle on vient positionner des puces semiconductrices 21, préalablement fabriquées et découpées selon des procédés habituels, sur une plaque de support 23. On notera que les puces 21 auront été préalablement testées selon des procédés habituels, par exemple sous pointe, directement sur la tranche de silicium, avant l'étape de découpe des puces 21. Ainsi, seules des puces 21 valides sont positionnées sur la plaque 23, ce qui permet de garantir un bon rendement de fabrication des composants munis d'extensions périphériques en résine. Les puces 21 sont positionnées sur la plaque 23 de façon que la face arrière des puces 21 reste libre. La face avant des puces 21 est par exemple collée à la plaque de support 23 par l'intermédiaire d'un adhésif à double face. En outre, un espace libre 25 est prévu entre des puces 21 voisines.

La figure 2B illustre une étape au cours de laquelle un dépôt de résine est effectué sur la plaque 23, de façon que la résine 27 vienne combler les espaces libres 25 (figure 2A) entre les puces 21. En pratique, dans un premier temps, l'épaisseur de la couche de résine 27 formée est supérieure à l'épaisseur des puces 21. Lors d'une étape ultérieure, la couche de résine 27 est amincie de façon à être mise à la même épaisseur que les puces 21. Ainsi, en vue de dessus (non représentée), chaque puce 21 est encadrée par une couronne de résine 27 solidaire de la puce, l'épaisseur de la résine 27 correspondant sensiblement à l'épaisseur des puces 21, par exemple de l'ordre de 250 à 450 µm.

La figure 2C illustre le positionnement de billes de contact 29 sur les puces 21 et sur les extensions de résine 27 correspondantes. Lors d'une étape intermédiaire, non représentée, la tranche constituée par les puces 21 et par les extensions de résine 27 est décollée de la plaque de support 23, et peut être retournée. Avant de positionner/fixer les billes 29, on aura déposé sur l'ensemble de la puce et des extensions de résine un empilement de couches isolantes et conductrices propre à former des connexions et des plots en surface, les connexions assurant la liaison entre les plots et des contacts sur la puce.

Lors d'une étape finale, les composants étendus sont découpés.

La figure 3 est une vue en coupe représentant de façon plus détaillée un composant 31 formé selon le procédé décrit en relation avec les figures 2A à 2C. A titre d'exemple, la puce semiconductrice de base 21 est une puce carrée de 4 mm de côté, et les extensions périphériques en résine 27 forment, autour de la puce 21, une couronne à bords carrés de 2 mm de large. Ainsi, l'ensemble de la puce 21 et de l'extension de résine 27 forme un carré de 8 mm de côté, sur lequel on peut prévoir une matrice de 16 x 16 billes de 0,25 à 0,35 mm de diamètre, avec un pas de 0,4 à 0,5 mm (centre à centre) entre deux billes voisines.

Un problème souvent rencontré dans les montages en surface réside dans la fragilité des billes de contact. En cas de choc, il arrive que des billes se fissurent, conduisant à des disfonctionnements du montage. Pour pallier cet inconvénient, on a proposé de noyer partiellement les billes dans une couche de résine de protection formée du côté de la face avant de la puce, et s'étendant sur une épaisseur comprise entre 40 et 70% de la hauteur des billes. On notera que lors de leur soudure aux plots de connexion, les billes 29 sont légèrement écrasées. Ainsi, des billes de diamètre de l'ordre de 0,25 à 0,35 mm de diamètre (horizontal) auront classiquement une hauteur finale de l'ordre de 0,2 à 0,25 mm.

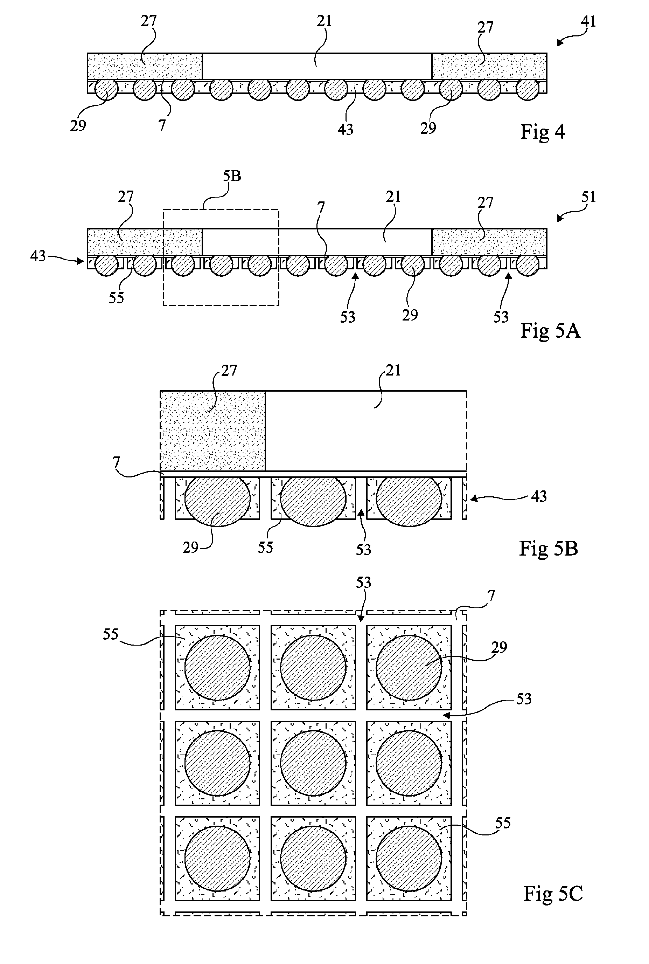

La figure 4 est une vue en coupe représentant un composant 41 comprenant les éléments du composant 31 de la figure 3, et comprenant en outre une couche de résine 43 de protection des billes 29. La couche 43 est par exemple formée par injection et/ou compression de résine du côté de la face avant de la puce, et s'étend jusqu'à environ 60% de la hauteur des billes. Lors de la formation de la couche 43, on utilise généralement un moule adapté à éviter tout dépôt de résine sur les calottes extrêmes des billes, de façon à pouvoir former ultérieurement des contacts électriques sur ces calottes. On notera que les résines de protection habituellement utilisées sont, aux températures normales de fonctionnement du composant, dures et rigides. Pour former la couche 43, la résine est chauffée, de façon à la rendre temporairement malléable.

La couche de résine 43 permet d'améliorer la résistance aux chocs des billes de contact 29. Toutefois, les billes restent susceptibles de se fissurer. En particulier, les billes 29 sont fragilisées par les contraintes mécaniques qui s'exercent dans un montage en surface lors des variations de température. En effet, un tel montage comprend différents matériaux présentant des coefficients de dilatation thermique distincts (résine 27 des extensions de la puce, résine de la couche 43, silicium de la puce 21, métal des billes 29, matériau de support de la carte de circuit imprimé, etc.). Ainsi, lors des variations de température, les billes sont soumises à des contraintes mécaniques importantes.

En outre, du fait de la différence de coefficient de dilatation thermique entre le substrat de la puce 21 et la couche de résine de protection 43, un gauchissement du composant à montage en surface est susceptible de se produire. En effet, lors des variations de température, le substrat de la puce et la résine 43 tendent à se dilater ou à se rétracter dans des mesures différentes. La résine 43 et le substrat de la puce étant des matériaux rigides, présentant peu d'élasticité ou de compressibilité, il en résulte un gauchissement de l'empilement.

Pour minimiser ce gauchissement, on a proposé de former, du côté de la face arrière de la puce, une couche de résine sensiblement identique à la couche de protection 43 formée du côté de la face avant. Ainsi, lors des variations de température, les contraintes exercées sur la puce par la couche 43 sont compensées par les contraintes, sensiblement opposées, exercées par la couche de résine de la face arrière. Toutefois, une telle solution nécessite de former une couche de résine supplémentaire, ce qui complique la fabrication du composant.

### Résumé

Ainsi, un objet d'un mode de réalisation de la présente invention est de prévoir un composant électronique à montage en surface palliant au moins en partie certains des inconvénients des solutions existantes.

Un objet d'un mode de réalisation de la présente invention est de prévoir un tel composant présentant une meilleure résistance aux chocs et/ou aux variations de température que les solutions existantes.

Un objet d'un mode de réalisation de la présente invention est de prévoir un tel composant facile à réaliser.

Ainsi, un mode de réalisation de la présente invention prévoit un composant électronique à montage en surface comprenant des billes fixées à sa face avant et, sur la face avant, une couche de résine de protection rigide d'épaisseur inférieure à la hauteur des billes, dans lequel des rainures s'étendent dans la couche de résine entre des billes de la puce.

Selon un mode de réalisation de la présente invention, les rainures s'étendent sur toute l'épaisseur de la couche de résine.

Selon un mode de réalisation de la présente invention, des groupes de billes juxtaposées sont encadrés par des rainures.

Selon un mode de réalisation de la présente invention, chaque groupe de bille comprend une seule bille.

Selon un mode de réalisation de la présente invention, la couche de résine a une épaisseur comprise entre 40 et 70 % de la hauteur des billes.

Selon un mode de réalisation de la présente invention, les billes ont un diamètre de 0,25 à 0,35 mm et sont espacées d'un pas de 0,4 à 0,5 mm, les rainures ayant une largeur comprise entre 20 et 70 µm.

Selon un mode de réalisation de la présente invention, le composant comprend en outre une couche d'arrêt de découpe entre la couche de résine et la face avant.

Selon un mode de réalisation de la présente invention, le composant comprend en outre une puce semiconductrice de base et une extension périphérique en résine.

Un autre mode de réalisation de la présente invention prévoit un procédé de fabrication d'un composant électronique à montage en surface comportant les étapes suivantes : fixer des billes à la face avant du composant ; former une couche de résine de protection rigide d'épaisseur inférieure à la hauteur des billes du côté de la face avant du composant ; et former des rainures dans la couche de résine, entre des billes de la puce.

Selon un mode de réalisation de la présente invention, les rainures sont formées à la scie ou à la scie et au laser.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1A, précédemment décrite, est une vue en coupe représentant de façon schématique une puce à montage en surface et un circuit imprimé adapté à recevoir cette puce ;
la figure 1B, précédemment décrite, est une vue de la face avant de la puce de la figure 1 ;
les figures 2A à 2C, précédemment décrites, sont des vues en coupe représentant très schématiquement des étapes de réalisation de puces à montage en surface munies d'extensions périphériques en résine ;
la figure 3, précédemment décrite, est une vue en coupe représentant de façon plus détaillée une puce étendue formée selon le procédé décrit en relation avec les figures 2A à 2C ;
la figure 4, précédemment décrite, est une vue en coupe représentant une puce du type décrit en relation avec la figure 3, comprenant en outre une couche de résine de protection des billes de contact de la puce ;
la figure 5A est une vue en coupe représentant de façon schématique un mode de réalisation d'une puce à montage en surface présentant une résistance améliorée aux chocs et/ou aux variations de température ;
la figure 5B est une vue en coupe représentant plus en détail une portion de la puce de la figure 5A ; et
la figure 5C est une vue de la face avant de la portion de puce de la figure 5B.

### Description détaillée

Par souci de clarté, de mêmes éléments ont été désignés par de mêmes références aux différentes figures et, de plus, comme cela est habituel dans la représentation des composants électroniques, les diverses figures ne sont pas tracées à l'échelle.

La figure 5A est une vue en coupe représentant de façon schématique un exemple d'un mode de réalisation d'une puce à montage en surface 51 présentant une résistance améliorée aux chocs et/ou aux variations de température. La figure 5B est un agrandissement d'une portion de la vue en coupe de la figure 5A. La figure 5C est une vue de la face avant de la portion de puce 51 de la figure 5B. On se référera ci-après à l'ensemble de ces trois figures.

Comme la puce 41 de la figure 4, la puce 51 est une puce munie d'extensions périphériques en résine, formée selon un procédé du type décrit en relation avec les figures 2A à 2C. La puce 51 est constituée d'une puce semiconductrice de base 21, par exemple d'épaisseur de l'ordre de 250 à 450 µm, comportant une extension périphérique en résine 27, sensiblement de même épaisseur. Des billes de contact 29 sont fixées à des plots de contact formés sur la puce 21 et sur les extensions en résine 27. Des métallisations de connexion, non représentées, relient ces plots à des zones de la puce à contacter.

Les billes 29 sont partiellement noyées dans une couche de résine de protection 43, formée du côté de la face avant de la puce, et s'étendant sur une épaisseur sensiblement uniforme, inférieure à la hauteur des billes. La résine 43 est une résine rigide, du type habituellement utilisé comme couche de protection ou d'encapsulation dans le domaine des composants semiconducteurs. Selon un mode de réalisation préféré, l'épaisseur de la couche 43 est comprise entre 40 et 70% de la hauteur des billes. A titre d'exemple, la hauteur des billes est de l'ordre de 0,2 à 0,25 mm, et l'épaisseur de la couche de résine 43 est de l'ordre de 0,1 à 0,2 mm.

Des rainures 53 quadrillent la couche de résine 43 entre les billes 29, délimitant une matrice d'îlots de résine 55, chaque îlot 55 contenant une bille 29. En pratique, chaque îlot occupe un volume sensiblement cubique, et contient une bille 29 formant une saillie du côté de sa face supérieure. Selon un mode de réalisation préféré, illustré par les figures 5A à 5C, les rainures 53 s'étendent, en profondeur, jusqu'à la couche isolante 7 formant la face avant de la puce. Toutefois, l'invention ne se restreint pas à ce cas particulier, et les rainures peuvent aussi s'arrêter légèrement avant la couche isolante 7.

Les rainures 53 sont réalisées par tout moyen adapté. On utilisera de préférence les outils usuels de découpe des puces semiconductrices, par exemple une scie ou un laser. On pourra aussi choisir de faire une pré-entaille à la scie, et de terminer la formation de la rainure à l'aide d'un laser. De façon optionnelle, on pourra prévoir une couche d'arrêt du laser entre la couche de résine 43 et la couche isolante 7. A titre d'exemple, et pour les dimensions de billes indiquées ci-dessus, la largeur des rainures est comprise entre 20 et 70 µm.

Un avantage de la structure proposée est que la prévision des rainures permet de réduire les contraintes mécaniques qui s'exercent dans la structure, notamment les contraintes liées aux différences de coefficient de dilatation thermique entre les différents matériaux dans un montage en surface. En effet, la prévision des rainures permet de laisser une certaine liberté de mouvement aux billes.

En particulier, la prévision des rainures permet d'éviter les phénomènes de gauchissement du composant à montage en surface liés à la différence de coefficient de dilatation thermique entre la résine de la couche 43 et le substrat de la puce (par exemple du silicium). Ainsi, il n'est plus nécessaire de prévoir une couche de résine supplémentaire du côté de la face arrière de la puce, pour compenser ce phénomène de gauchissement.

Un autre avantage de la structure proposée est que les rainures 53 sont faciles à réaliser, notamment en utilisant des outils de découpe usuels.

Des modes de réalisation particuliers de la présente invention ont été décrits. Diverses variantes et modifications apparaîtront à l'homme de l'art.

En particulier, l'invention ne se restreint pas au cas particulier décrit en relation avec les figures 5A à 5C, dans lequel le composant à montage en surface est une puce étendue, comportant une extension périphérique en résine. L'homme de l'art saura notamment mettre en oeuvre le fonctionnement recherché dans le cas où le composant à montage en surface est une puce semiconductrice classique ne comportant pas d'extension en résine.

En outre, les dimensions mentionnées dans la présente description sont données uniquement à titre d'exemple. L'invention ne se restreint pas à ces cas particuliers.

Par ailleurs, on a mentionné ci-dessus un exemple de réalisation dans lequel chaque bille de la puce est encadrée par des rainures 53. L'invention ne se restreint pas à ce cas particulier. On pourra aussi prévoir de former les rainures 53 autour de groupes de billes juxtaposées, par exemple disposées en carré ou en rectangle.

## Revendications

1. Composant électronique (51) à montage en surface comprenant des billes (29) fixées à sa face avant et, sur la face avant, une couche de résine de protection (43) rigide d'épaisseur inférieure à la hauteur des billes, dans lequel des rainures (53) s'étendent dans la couche de résine (43) entre des billes de la puce.

2. Composant selon la revendication 1, dans lequel les rainures s'étendent sur toute l'épaisseur de la couche de résine (43).

3. Composant selon la revendication 1 ou 2, dans lequel des groupes de billes juxtaposées sont encadrés par des rainures (53).

4. Composant selon la revendication 3, dans lequel chaque groupe de bille comprend une seule bille.

5. Composant selon l'une quelconque des revendications 1 à 4, dans lequel la couche de résine (43) a une épaisseur comprise entre 40 et 70 % de la hauteur des billes.

6. Composant selon l'une quelconque des revendications 1 à 5, dans lequel les billes ont un diamètre de 0,25 à 0,35 mm et sont espacées d'un pas de 0,4 à 0,5 mm, les rainures ayant une largeur comprise entre 20 et 70 µm.

7. Composant selon l'une quelconque des revendications 1 à 6, comprenant en outre une couche d'arrêt de découpe entre la couche de résine et la face avant.

8. Composant selon l'une quelconque des revendications 1 à 7, comprenant une puce semiconductrice de base (21) et une extension périphérique en résine (27).

9. Procédé de fabrication d'un composant électronique (51) à montage en surface comportant les étapes suivante :
fixer des billes (29) à la face avant du composant ;
former une couche (43) de résine de protection rigide d'épaisseur inférieure à la hauteur des billes du côté de la face avant du composant ; et
former des rainures (53) dans la couche de résine, entre des billes de la puce.

10. Procédé selon la revendication 9, dans lequel les rainures (53) sont formées à la scie ou à la scie et au laser.
